# DEMANDE DE BREVET EUROPEEN

(11) **EP 0 603 069 A1**
(43) Date de publication de la demande: **22.06.1994**
(21) Numéro de dépôt: 93403036.2
(22) Date de dépôt: 15.12.1993
(51) Int. Cl.: H01S 3/18

(54) **Laser à cavité verticale de faible résistance**

(30) Priorité: 15.12.1992 FR 9215090
(71) Demandeur: FRANCE TELECOM, F-75015 Paris (FR)
(72) Inventeur: Deveaud-Pledran, Benoît, F-22300 Lannion (FR); Loualiche, Slimane, F-22300 Lannion (FR)
(74) Mandataire: Martin, Jean-Jacques

(57) **Abrégé**

La présente invention concerne une structure laser à émission verticale comprenant une région active (10) encadrée par des empilements (30, 32) de couches formant mirroirs à réflection de Bragg respectivement de type n et de type p, caractérisée par le fait que les empilements de couches (30, 32) sont formés de couples de matériaux différents pour le miroir de type n et le mirroir de type p, le couple de matériaux constituant le mirroir du type n (32) est formé de matériaux qui possèdent une faible discontinuité de bande de conduction, et le couple de matériaux constituant le mirroir de type p est formé de matériaux qui possèdent une faible discontinuité de bande de valence.

## Description

la présente invention concerne le domaine des structures lasers.

Les techniques de croissance modernes ont permis la réalisation de structures lasers très diverses.

L'une de ces structures lasers, qui a été réalisée au cours des dernières années, est dénommée "laser à cavité verticale".

Ces lasers à cavité verticale ont donné lieu à une littérature très abondante.

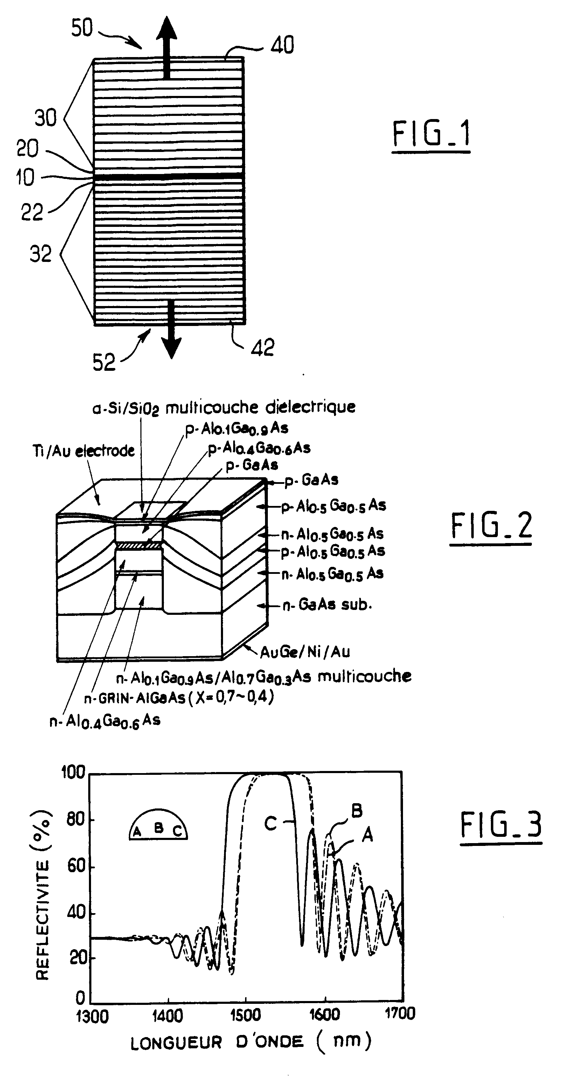

Comme cela est schématisé sur la figure 1 annexée, les lasers à cavité verticale comprennent généralement et pour l'essentiel une région active de recombinaison 10 encadrée de part et d'autre par des régions de confinement 20, 22, elles-mêmes placées entre des zones formant miroirs 30, 32.

La zone inférieure 32 formant miroir est placée sur un substrat 42, tandis que la zone supérieure 30 formant miroir reçoit une couche de contactage 40 servant à l'injection.

Le bon fonctionnement de ces structures repose sur la réalisation de miroirs 30, 32 de bonne qualité, au-dessus et au-dessous de la partie active 10 du composant.

La façon la plus efficace de réaliser de tels miroirs 30, 32 consiste à réaliser un empilement répété de deux couches transparentes, d'indices différents, et d'épaisseur égale à λ/4 pour chacune des couches.

Sur la figure 1, on a schématisé sous la référence 50 I'émission verticale obtenue vers le haut à travers le miroir 30, et sous la référence 52 l'émission verticale vers le bas obtenue à travers le miroir 32.

On pourra se référer utilement au document J.L. Jewell, J.P. Harbison, A. Sheer, Y.H. Lee, L.T. Florez, IEEE J. Quantum Electron. QE-27, p. 1332-1346 (1991) pour une description schématique d'une telle structure laser correspondant à la figure 1.

Par ailleurs, on pourra se référer au document M. Shimada, T. Asaka, Y. Yamasaki, H. Iwano, M. Ogura, S.Mukai, Appl. Phys. Lett., 57, p. 1289-1291 (1990) pour une description plus compète d'un laser réel, tel que représenté sur la figure 2.

Ce type de miroir formé d'un empilement de couches transparentes est appelé DBR correspondant à l'expression anglo-saxone Distributed Bragg Reflector' et pour l'expression francophone "Miroir à Réflection de Bragg".

De telles structures laser à émission verticale comprenant des miroirs à réflection de Bragg sont particulièrement faciles à réaliser dans les matériaux à base de GaAs puisque les couches de AlAs et de AlGaAs avec environ 20% d'AI présentent une différence d'indice suffisante et sont aisément épitaxiables l'un sur lautre.

Des structures de ce type ont été réalisées dans de nombreuses configurations.

Il existe cependant une difficulté qui est la forte résistance électrique de contact des couches réfléchissantes 30, 32.

Cette forte résistance de contact est liée aux discontinuités de bande à chacune des interfaces, discontinuités qui ralentissent le passage de porteurs de charge.

Diverses solutions ont été envisagées pour essayer de remédier à cette difficulté: par exemple, la réalisation de couches de transition en superréseau à période variable, ou bien l'incorporation de couches de dopants alternées qui constituent des dipoles d'interface et qui limitent la discontinuité.

On notera que selon la structure laser à émission verticale représentée sur la figure 2, le contact de type p ne passe pas par un miroir de Bragg pour minimiser la résistance du dispositif.

Toutes ces modifications apportent des améliorations, mais pas de changements importants, puisque la résistance électrique interne du dispostif reste très grande.

On pourra notamment se référer sur ce point au document J.L. Jewell, Y.H. Lee, A. Scherer, S.L. McCall, N.A. Olsson, Opt. Eng., 29, p. 210-214 (1990).

Si par contre on s'intéresse aux longueurs d'ondes utiles pour les télécommunications optiques, c'est-à-dire 1,3 ou 1,55µm, on doit passer à des composants sur substrat 42 en InP.

Dans ce cas de figure, on conserve les inconvénients du système GaAs avec deux difficultés supplémentaires. Tout d'abord, la longueur d'onde étant plus grande, il faut réaliser des couches plus épaisses.

Par ailleurs, les différences d'indice sont plus faibles et il faut donc empiler un nombre de couches 32 plus élevé pour parvenir à un coefficient de réflection suffisant.

A titre d'exemple, W. Tsang n'a pu réaliser un miroir DBR sur InP de bonne qualité qu'avec une épaisseur totale de 11µm.

Ce laser est décrit dans la publication F.S. Choa, K. Tai, W.T. Tsang, S.N.G. Chu, Appl. Phys. Lett., 59, p. 2820-2822 (1991).

On montre sur la figure 3 la réflectivité du miroir DBR composé de 45 périodes successives de InP/InGaAsP proposées par W. Tsang.

La présente invention a maintenant pour but de perfectionner les structures existantes.

Ce but est atteint selon la présente invention grâce à une structure laser à émission verticale comprenant une région active encadrée par des empilements de couches formant miroirs à réflection de Bragg respectivement de type n et de type p, caractérisée par le fait que
- les empilements de couches sont formés de couples différents pour le miroir de type n et le miroir de type p,
- le couple constituant le miroir de type n est constitué de matériaux qui possèdent une faible discontinuité de bande de conduction, voire pas de discontinuité de bande de conduction, et
- le couple constituant le miroir de type p est formé de matériaux qui possèdent une faible discontinuité de bande de valence, voire pas de discontinuité de bande de valence.

Selon une autre caractéristique avantageuse de la présente invention, le couple constituant le miroir de type n est formé de matériaux qui présentent une forte discontinuité de bande de valence.

Selon une autre caractéristique avantageuse de la présente invention, le couple de matériaux du miroir de type p est formé de matériaux qui possèdent une forte discontinuité de bande de conduction.

Selon une autre caractéristique avantageuse de la présente invention, les couples de matériaux utilisés présentent des différences d'indices supérieures à 0,20.

Selon une autre caractéristique avantageuse de la présente invention, le nombre de couches utilisées pour chaque miroir est adapté pour définir une réflectivité supérieure à 80%, de préférence supérieure à 90%.

Selon une autre caractéristique avantageuse de la présente invention, le nombre de couches utilisées pour chaque empilement est inférieur à 20.

Comme on le verra par la suite, la structure ainsi proposée dans le cadre de la présente invention permet de remédier aux inconvénients majeurs de la technique antérieure.

D'autres caractéristiques, buts et avantages de la présente invention apparaîtront à la lecture de la description détaillée qui va suivre, et qui concerne un mode de mise en oeuvre préférentiel de la présente invention.

On rappelle que sur les figures annexées:
- la figure 1 représente une vue schématique en coupe verticale d'une structure classique de laser à émission verticale conforme à l'état de la technique,
- la figure 2 représente une vue schématique partielle en perspective éclatée d'un mode de réalisation particulier d'une telle structure laser à émission verticale conforme à l'état de la technique, et
- la figure 3 représente, en fonction de la longueur d'onde, la réflectivité d'un miroir DBR connu composé de 45 répétitions successives de InP/InGaAsP en λ/4.

La structure laser conforme à la présente invention est réalisée par épitaxies successives de diverses couches sur un substrat 42 en InP, comme cela est connu, dans le principe, de l'art antérieur et représenté schématiquement sur la figure 1.

Plus précisément, dans le cadre de la présente invention on dépose successivement sur le substrat 42, des couples de couches 32 formant miroirs de Bragg de type n, une couche de confinement 22, la couche active 10, une seconde couche de confinement 20 et un empilement de couples de couches 30 formant miroirs de Bragg de type p, puis une couche d'injection 40.

Selon la caractéristique essentielle de la présente invention, évoquée ci-dessus, les empilements de couches 30 et 32 sont formés de couples différents pour le miroir de type n et le miroir de type p.

Plus précisément, le couple constituant le miroir 32 de type n est formé de matériaux qui possèdent une faible discontinuité de bande de conduction, voire pas de discontinuité de bande de conduction, tandis que le couple de matériaux constituant le miroir de type p 30 est formé de matériaux qui possèdent une faible discontinuité de bande de valence, voire par de discontinuité de la bande de valence.

Selon une autre caractéristique préférentielle, comme indiqué précédemment, afin de former barrière aux trous et électrons injectés, au-delà de la zone active 10, le couple constituant le miroir de type n présente une forte discontinuité de bande de valence, tandis qu'à l'inverse le couple constituant le miroir de type p est formé de matériaux qui possèdent une forte discontinuité de bande de conduction.

Par ailleurs, dans le cadre de l'invention, il est proposé des couples de matériaux à l'accord de maille sur le substrat 42 en InP.

Selon un mode de réalisation particulièrement avantageux, le miroir de type n est formé du couple de matériaux suivant tous deux à l'accord de maille sur le substrat InP:
Al_{0,48}In_{0,52}As/GaAs_{0,51}Sb_{0,49}

Le matériau Al_{0,48}In_{.0,52}As présente un intervalle de bande interdite de 1,5 eV et un indice de 3,20.

De son côté, le matériau GaAs_{0,51}Sb_{0,49} présente un intervalle de bande interdite de 0,8 eV et un indice de 3,75.

Les deux matériaux Al_{0,48}In_{0,52}As et GaAs_{0,51}Sb_{0,49} présentent une discontinuité de bande de conduction de 10meV.

Dans le cadre de la présente invention, le couple de matériaux, tous deux à l'accord de maille sur le susbtrat InP, pour le miroir 30 de type p est le suivant: AlAs_{0,51}Sb_{0,49}/Al_{0,48}In_{0,52}As.

Le matériau Al_{0,48}In_{0,52}As présente un intervalle de bande interdite de 1,5 eV et un indice de 3,20.

De son côté, le matériau AlAs_{0,51}Sb_{0,49} présente un intervalle de bande interdite de 1,65 eV et de 3,40.

Les deux matériaux précités AlAs_{0,51}Sb_{0,49} et Al_{0,48}In_{0,52}As présentent une discontinuité de bande de valence nulle.

Grâce à l'utilisation des deux couples de matériaux précités, on peut réaliser des miroirs de Bragg sous forme d'un empilement de couches de 1.172Å de Al_{0,48}In_{0,52}As et de 1.000Å de GaAs_{0,51}Sb_{0,49}.

Pour la réalisation de miroirs de Bragg de type p, on peut procéder à un empilement de couches de 1.172Å de Al_{0,48}In_{0,52}As et de 1.103Å de AlAs_{0,51}Sb_{0,49}.

La présente invention permet ainsi de réduire le nombre de couches nécessaires à la réalisation du miroir de type n de 45 à 12, c'est-à-dire l'épaisseur totale de 11µm à 3µm.

De la même façon, la résistance de la couche de type p est ramenée de 100ohms à environ 3ohms.

Ainsi, on comprend que la présente invention permet à la fois de diminuer la résistance électrique interne de la structure laser et de diminuer son épaisseur totale.

Bien entendu, la présente invention n'est pas limitée au mode de réalisation particulier qui vient d'être décrit, mais s'étend à toutes variantes conformes à son esprit.

## Revendications

1. Structure laser à émission verticale comprenant une région active (10) encadrée par des empilements (30, 32) de couches formant miroirs à réflection de Bragg respectivement de type n et de type p, caractérisée par le fait que:
- les empilements de couches (30, 32) sont formés de couples de matériaux différents pour le miroir de type n et le miroir de type p,
- le couple de matériaux constituant le miroir du type n (32) est formé de matériaux qui possèdent une faible discontinuité de bande de conduction, voire pas de discontinuité de bande de conduction, et
- le couple de matériaux constituant le miroir de type p est formé de matériaux qui possèdent une faible discontinuité de bande de valence, voire pas de discontinuité de bande de valence.

2. Structure laser selon la revendication 1 caractérisée par le fait que le couple de matériaux constituant le miroir de type n (32) est constitué de matériaux qui possèdent une forte discontinuité de bande de valence.

3. Structure laser selon l'une des revendication 1 ou 2 caractérisée par le fait que le couple de matériaux constituant le miroir de type p est formé de matériaux qui possèdent une forte discontinuité de bande de conduction.

4. Structure laser selon l'une des revendications 1 à 3 caractérisée par le fait que les couples de matériaux composants respectivement chaque empilement de couches (30, 32) présentent une différence d'indice supérieure à 0,20, et le nombre de couches de chaque empilement est égal à 20.

5. Structure laser selon l'une des revendications 1 à 4 caractérisée par le fait que le nombre de couches composant chaque empilement (30, 32) est adapté pour définir une réflectivité supérieure à 80%, de préférence supérieure à 90%.

6. Structure laser selon l'une des revendications 1 à 5 caractérisée par le fait qu'elle comprend un substrat (42) en InP et par le fait que chacun des matériaux utilisés pour les empilements (30, 32) formant miroir de Bragg est à l'accord de maille sur le substrat (42) en InP.

7. Structure laser selon l'une des revendications 1 à 6 caractérisée par le fait que le couple de matériaux utilisé pour le miroir de type n est le suivant:
Al_{0,48}In_{0,52}As/GaAs0,51^{Sb}0,49^{.}

8. Structure laser selon la revendication 7 caractérisée par le fait que le miroir de type n est formé d'un empilement de couches de 1.172.Å de Al_{0,48}In_{0,52}As et de 1.000Å de GaAs_{0,51}Sb_{0,49}.

9. Structure laser selon l'une des revendications 1 à 8 caractérisée par le fait que le miroir de type n est formé d'un empilement de l'ordre de 12 couches alternées de Al_{0,48}In_{0,52}As et GaAs_{0,51}Sb_{0,49}.

10. Structure laser selon l'une des revendications 1 à 9 caractérisée par le fait que le couple de matériau utilisé pour la réalisation du miroir de type p est le suivant:
AlAs_{0,51}Sb_{0,49}/Al_{0,48}In_{0,52}As.

11. Structure laser selon la revendication 10 caractérisée par le fait que le miroir de type p est obtenu par empilement de couches de 1.172Å de Al_{0,48}In_{0,52}As et de 1.103Å de AlAs_{0,51}Sb_{0,49.}
